# EUROPEAN PATENT APPLICATION

(11) **EP 2 320 196 A1**
(43) Date of publication of application: **11.05.2011**
(21) Application number: 09802933.3
(22) Date of filing: 28.07.2009
(51) Int. Cl.: G01D 5/245, G01R 33/09

(54) **MAGNETIC DETECTOR**

(30) Priority: 29.07.2008 JP 2008195190; 02.03.2009 JP 2009047476
(71) Applicant: Alps Electric Co., Ltd., Tokyo 145-8501 (JP)
(72) Inventor: ANDO, Hideto, Tokyo 145-8501 (JP); ABE, Tomio, Tokyo 145-8501 (JP); OBANA, Masayuki, Tokyo 145-8501 (JP); MAEKAWA, Shuji, Tokyo 145-8501 (JP); MIZUTANI, Naoki, Tokyo 145-8501 (JP); NAKAMURA, Tokuo, Tokyo 145-8501 (JP); HATTORI, Yasuyuki, Tokyo 145-8501 (JP)
(74) Representative: Klunker . Schmitt-Nilson . Hirsch
(86) International application number: PCT/JP2009/063380
(87) International publication number: WO 2010/013690

(57) **Abstract**

A magnetic detection device is proposed which is able to use a plurality of magnetoresistance effect elements and obtain a plurality of magnetic detection outputs. There are two detection units 15A and 15B on a common substrate 11. Each of the detection units 15A and 15B have the same configuration, and a magnetoresistance effect element 55 and a fixed resistor 56 are connected in series and formed on a circuit configuring layer 20 which configures a detection circuit. On the surface of each of the detection units 15A and 15B, a ground terminal portion 31, a power source terminal portion 32 and an output terminal portion 33 are provided. In the left and right detection units 15A and 15B, positive potential applying portions are connected to each other by a power source line portion 17 and ground portions are connected to each other by a ground line portion 18. As such, it is possible for there to be conduction between the two detection units 15A and 15B using any one of the ground terminal portions 31 and any one of the power source terminal portions 32. In addition, it is possible to obtain a detection output individually from each of the output terminal portions 33 and 33 of the detection units 15A and 15B.

## Description

This application is a Continuation of International Application No. PCT/JP2009/063380 filed on Month d, 200XX, which claims benefit of Japanese Patent Application No. 2008-195190 filed on July 29, 2008 and No. 2009-047476 filed on March 2, 2009. The entire contents of each application noted above are hereby incorporated by reference.

### BACKGROUND OF THE INVENTION

### 1. Field of the Invention

The present invention relates to a magnetic detection device where a plurality of detection units which have a magnetoresistance effect element is provided on the same substrate and individual detection outputs can be obtained from each of the detection units.

### 2. Description of the Related Art

As described in Japanese Unexamined Patent Application Publication No. 2007-271608 below, a magnetic detection device is used which uses a magnetoresistance effect element in a magnetic encoder which detects moving magnets and the like. The magnetic detection device has a bridge circuit which includes a magnetoresistance effect element and can obtain a voltage change from the bridge circuit according to a change in strength of a magnetic field used in the magnetoresistance effect element when the north pole and the south pole of a magnet are alternately moved. The relationship between the voltage change and time resembles a trigonometric curve and it is possible to recognize the movement state of the magnet by detecting the voltage change.

Additionally, a magnetic detection device is also used where a plurality of magnetoresistance effect elements is mounted thereon and individual detection outputs are obtained from each of the magnetoresistance effect elements. For example, in a magnetic encoder, when one cycle of a change of the north pole and the south pole of a moving magnet is 360 degrees, it is possible to distinguish the movement direction of the magnet by disposing the magnetoresistance effect elements to open up a distance so that there is a 90 degree phase difference with regard to the cycle.

In this case, a typical structure is where one magnetoresistance effect element and one circuit are mounted on one substrate, one magnetic detection device is configured for each substrate, and a plurality of the magnetic detection devices is lined up and disposed. However, in a structure such as this, an operation of individually attaching substrates which configure individual magnetic detection devices and an operation of positioning the substrates relative to one another are necessary, and furthermore, it is necessary to individually wire so as to supply a voltage to the detection circuits on each of the substrates so that the wiring operation is also complex.

### SUMMARY OF THE INVENTION

It is desirable to provide a magnetic detection device which can stabilize and precisely perform the relative positioning of a plurality of magnetoresistance effect elements by disposing a plurality of detection units which each has a magnetoresistance effect element and a detection circuit on the same substrate.

Also, it is desirable to provide a magnetic detection device which can supply a driving voltage to all detection units by selecting any terminal portion individually provided for each detection unit and connecting to a power source or ground connection.

According to an embodiment of the invention, a plurality of detection units, which has a magnetoresistance effect element and a detection circuit which detects a change in a resistance value of the magnetoresistance effect element, is provided on the same substrate, and each of the detection units is individually provided with a power source terminal portion which applies a positive potential, a ground terminal portion which sets a ground potential, and an output terminal portion which obtains a detection output generated by the detection circuit based on a change in the resistance value, and a plurality of positive potential applying portions of the detection units are connected to each other by a power source line portion and a plurality of ground portions of the detection units are connected to each other by a ground line portion, so that it is possible to apply a positive potential to all of the positive potential applying portions of the detection units using any one of the power source terminal portions and to set a ground potential in all of the ground portions of the detection units using any one of the ground terminal portions, and it is possible to obtain a detection output of each of the detection units from the respective output terminal portions.

Since the magnetic detection device of the embodiment of the invention has the plurality of detection units mounted on a common substrate, it is possible to precisely determine the positional relationship of the magnetoresistance effect elements provided in the respective detection units. Additionally, each of the detection units has a power source terminal portion and the ground terminal portion, but it is possible to apply power to all of the detection units only by selecting any one of the power source terminal portions and any one of the ground terminal portions and applying a voltage between both of the terminal portions.

Additionally, since the detection output according to a change in a magnetic field acted on by the respective magnetoresistance effect elements can be individually obtained for each of the detection units from the output terminal portions provided for the respective detection units, it is also possible to use all of the outputs of the detection units at the same time, and furthermore, it is possible to use only any of the detection outputs of the detection units.

In the embodiment of the invention, it is desirable to provide a blank region with a strip shape where the magnetoresistance effect element and the detection circuit do not exist between the adjacent detection units, and for the power source line portion which connects the positive potential applying portions of the adjacent detection units and the ground line portion which connects the ground portions of the adjacent detection units to cross the blank region.

When the providing of the blank region as described above is applied in a manufacturing stage to the purpose as the single detection unit, by cutting the substrate in the blank region, it is possible to use each of the detection units as the independent magnetic detection devices.

It is desirable if each of the detection units has a fixed resistor connected in series with the magnetoresistance effect element, and one end portion of the magnetoresistance effect element and the fixed resistor connected in series is set as the positive potential applying portion and the other end portion thereof is set as the ground portion, and the potential at the midpoint of the magnetoresistance effect element and the fixed resistor is applied to the detection circuit.

Also, it is desirable if there is a configuration where, on a circuit configuring layer which configures the detection circuit, each of the detection units is formed of the magnetoresistance effect element, the fixed resistor, an electrode layer which connects between the magnetoresistance effect element and the fixed resistor, an electrode layer connected to the other terminal of the magnetoresistance effect element, and an electrode layer connected to the other end of the fixed resistor, and where, in each of the detection units, the power source line portion and the ground line portion are formed on the circuit configuring layer.

In the configuration described above, after a plurality of active parts and the like are formed as thin film on a substrate and the detection circuit is configured as an integrated circuit, it is possible to pattern and form the magnetoresistance effect element and the fixed resistor on the circuit configuring layer which configures the integrated circuit.

It is desirable if a power source relay terminal and a ground relay terminal are provided on the circuit configuring layer, and using a connection line provided at an inner portion of the circuit configuring layer, the power source terminal portion and the power source relay terminal are connected and the ground terminal portion and the ground relay terminal are connected.

It is desirable if the power source relay terminal is connected to the power source line portion and the ground relay terminal is connected to the ground line portion.

Also, it is desirable if, in each of the detection units, a right-side power source coupling terminal and a right-side ground coupling terminal are provided on one side portion facing the arrangement direction of the detection unit, a left-side power source coupling terminal and a left-side ground coupling terminal are provided on the other side portion, the power source terminal portion and each of the left-side and right-side power source coupling terminals are connected by a connection line, and the ground terminal portion and each of the left-side and right-side ground coupling terminals are connected by a connection line, and where, between the adjacent detection units, the right-side power source coupling terminal of one detection unit and the left-side power source coupling terminal of another detection unit are connected by the power source line portion and the right-side ground coupling terminal of one detection unit and the left-side ground coupling terminal of another detection unit are connected by the ground line portion.

In this case, it is desirable if the embodiment of the invention has a configuration where, on the circuit configuring layer which configures the detection circuit, each of the detection units is formed of the magnetoresistance effect element, the fixed resistor, an electrode layer which connects between the magnetoresistance effect element and the fixed resistor, an electrode layer connected to the end of the magnetoresistance effect element, and an electrode layer connected to the other end of the fixed resistor, and where the connection line is wired in an inner portion of the circuit configuring layer, and the right-side and left-side power source coupling terminals and the right-side and left-side ground coupling terminals are provided on the circuit configuring layer.

As described above, by disposing the power source coupling terminal and the ground coupling terminal between both side portions of the respective detection units, it is possible to configure the power source line portion and the ground line portion which connect the left and right detection units to be as short as possible, and it is possible to make the resistance value of the power source line portion and the ground line portion to be low. Additionally, by disposing the power source coupling terminal and the ground coupling terminal at both side portions of each of the detection units and providing the connection line in an inner portion of a line layer, it is not necessary to form the line layer on the circuit configuring layer. As a result, it is possible to use a wide region on the circuit configuring layer as a formation region of the magnetoresistance effect element and the fixed resistor, and it is possible to reduce the size of the detection unit.

By forming the connection line in the inner portion of the line layer as described above, the cross-sectional area of the connection line may be made to be larger than the cross-section of the power source line portion and the ground line portion, and the resistance value per unit length of the connection line may be made to be smaller than the resistance value per unit length of the power source line portion and the ground line portion.

Furthermore, it is desirable if the arrangement pattern of the magnetoresistance effect element and the fixed resistor, the power source terminal portion and the ground terminal portion, and the output terminal portion are the same for all of the detection units.

Alternatively, the arrangement patterns of the magnetoresistance effect element and the fixed resistor, the power source terminal portion, the ground terminal portion, and the output terminal portion for adjacent detection units may be line-symmetric via a boundary portion of the detection units.

As described above, it is possible to form the plurality of detection units in the same manufacturing process at the same time.

Furthermore, it is desirable if the magnetoresistance effect element is disposed to be closer to a predetermined edge portion of the substrate than the fixed resistor in all of the detection units.

It is desirable if, in this case, there is a configuration which has a rotation magnet which has an outer circumference surface where the north pole and the south pole are alternatively magnetized toward the rotation direction, the predetermined edge portion of the substrate which has two detection units faces the outer circumference surface of the rotation magnet, and when the rotation magnet rotates, detection outputs where the phases differ from each other can be obtained from the output terminal portions of the two detection units.

In the configuration described above, when the outer circumference surface of the rotation magnet faces the substrate, it is possible to dispose the magnetoresistance effect element to be closer to the outer circumference surface of the rotation magnet which is a magnetized surface and it is possible to increase sensitivity of detecting a magnetic field from the rotation magnet.

According to the embodiment of the invention, it is possible to precisely position and dispose the plurality of magnetoresistance effect elements of the detection units relative to each other. Additionally, by selecting and applying a voltage to either the power source terminal portion or the ground terminal portion provided in each of the detection units, it is possible to supply driving power to all of the detection units. In addition, since it is possible to generate a detection output individually from each of the detection units, it is possible to use all of the detection units together or use the detection units individually.

Furthermore, it is possible to configure each of the detection units as a small size, and even if in a case when the plurality of detection units is disposed on the common substrate, it is possible to reduce the number of wire bondings for wiring to an external portion and the like.

### BRIEF DESCRIPTION OF THE DRAWINGS

Fig. 1 is a planar diagram illustrating a magnetic detection encoder as a magnetic detection device according to the present invention;
Fig. 2 is a planar diagram of a magnetic detection device according to a first embodiment of the present invention;
Fig. 3 is an enlarged diagram of a cross section cut along a line III-III of the magnetic detection device shown in Fig. 2;
Fig. 4 is a circuit diagram illustrating a circuit configuration of one detection unit provided in the magnetic detection device;
Fig. 5 is a planar diagram of a magnetoresistance effect element;
Fig. 6 is an enlarged diagram of a cross section cut along a line VI of the magnetoresistance effect element shown in Fig. 5;
Figs. 7A and 7B are waveform diagrams illustrating an operation of a detection circuit;
Fig. 8 is a planar diagram of a magnetic detection device according to a second embodiment of the present invention; and
Fig. 9 is a planar diagram of a magnetic detection device according to a third embodiment of the present invention.

### DESCRIPTION OF THE PREFERRED EMBODIMENTS

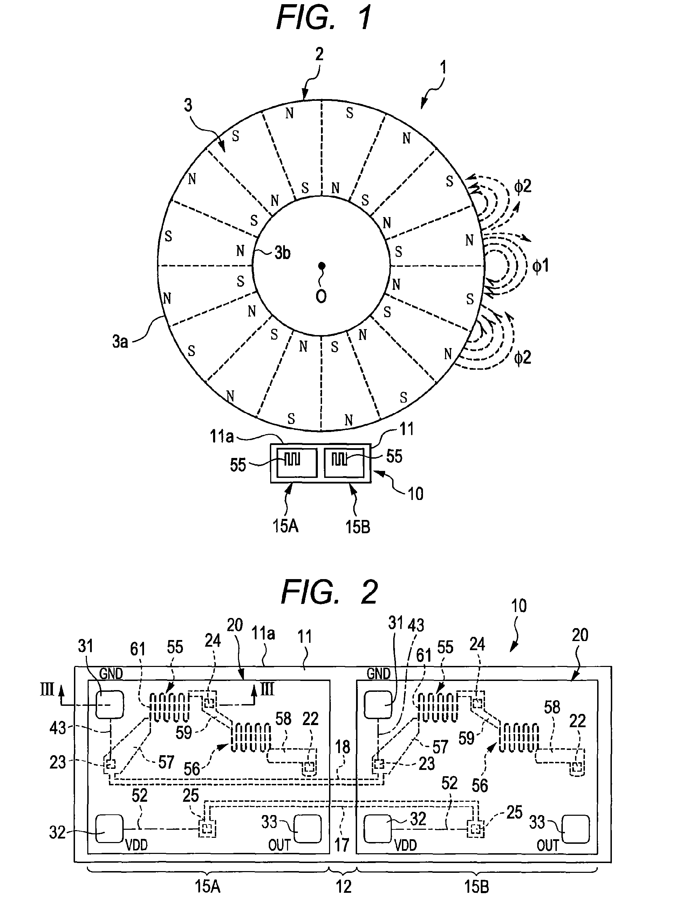

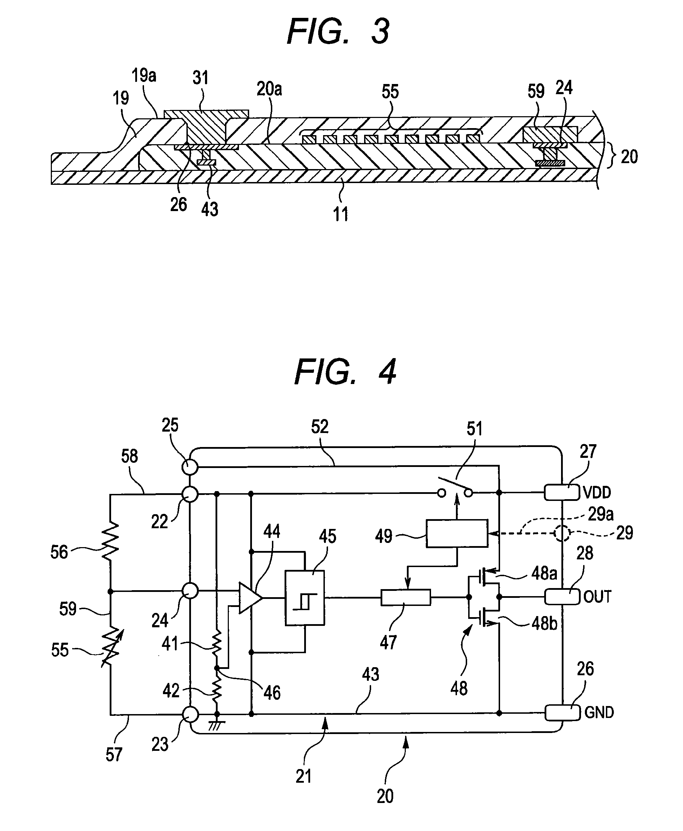

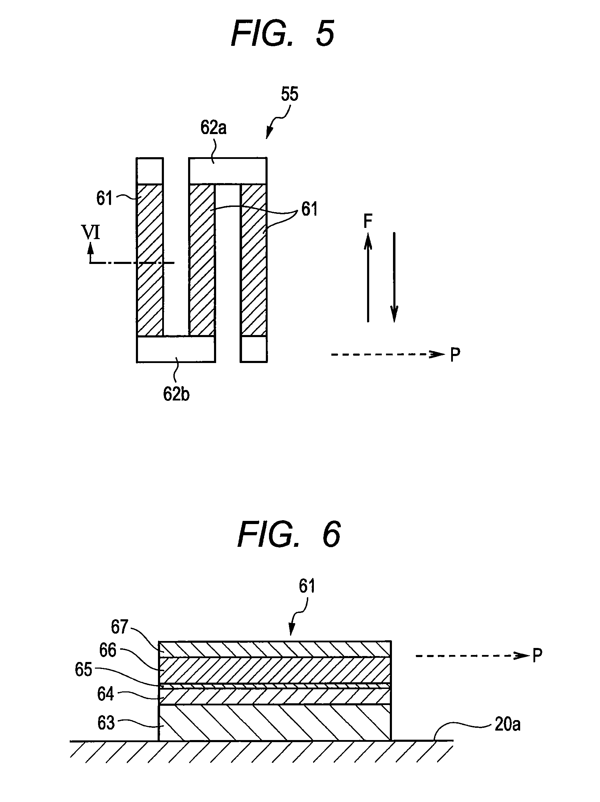

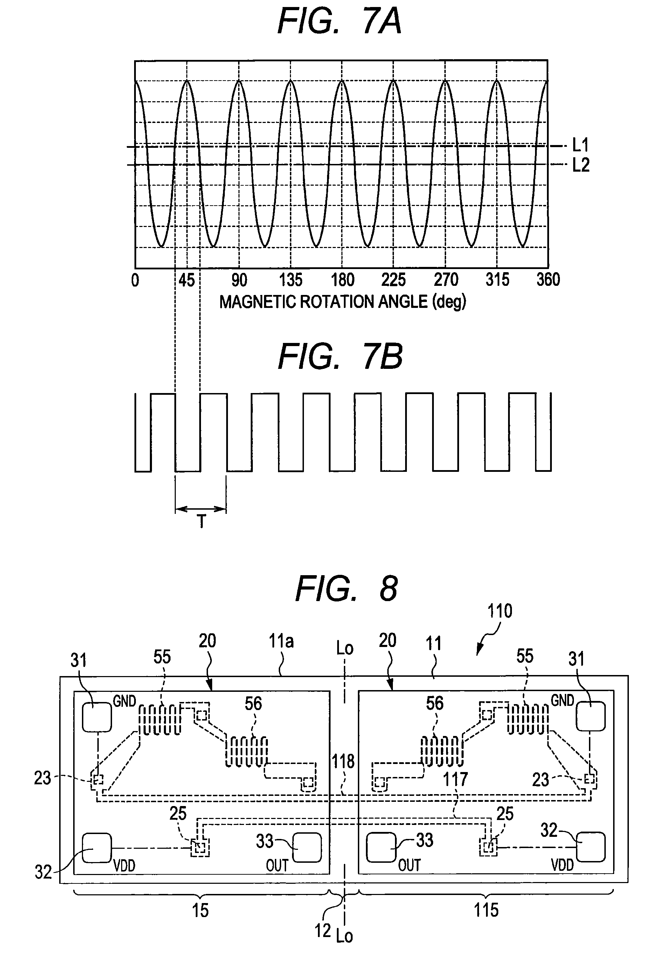

Fig. 1 is a planar diagram illustrating a magnetic detection encoder as one example of a device using a magnetic detection device according to the present invention. Fig. 2 is a planar diagram of a magnetic detection device according to a first embodiment, and Fig. 3 is a cross-sectional enlarged diagram cut along a line III-III of the magnetic detection device shown in Fig. 2. Fig. 4 is a circuit diagram of one detection unit. Fig. 5 is a planar diagram of a magnetoresistance effect element provided in the detection unit, and Fig. 6 is a cross-sectional enlarged diagram cut along a line VI of the magnetoresistance effect element shown in Fig. 5. Figs. 7A and 7B are operation description diagrams illustrating an operation of the detection circuit provided in each of the detection units.

A magnetic detection encoder 1 shown in Fig. 1 is provided with a detection rotor 2 which is capable of rotating with a rotation axis O as a center, and is provided with a rotation magnet 3 in an outer circumference portion of the detection rotor 2. The rotation magnet 3 is a thin ring shape where the thickness dimension along the axial direction of the rotation axis O is smaller than its radius. The rotation magnet 3 is divided up into 16 poles towards the circumference direction and is magnetized, and is a magnetic pole where an outer circumference surface 3a and an inner circumference surface 3b are opposites. In the outer circumference surface 3a, a north pole and a south pole are alternatively magnetized toward a rotation direction, an opening angle of the magnetized range of the magnetic pole of each of the north pole and the south pole is 22.5 degrees, and the rotation angle equivalent to one cycle of a change in the magnetic field changing from the north pole to the south pole is 45 degrees.

As shown in Fig. 1, in a region facing the outer circumference surface 3a of the rotation magnet 3, leakage of magnetic field is generated where the direction of the magnetic field changes in a planar surface perpendicular with the rotation axis O. The leakage of magnetic field has magnetic flux ϕ1 which changes in a clockwise direction from the north pole toward the south pole in the outer circumference surface 3a and magnetic flux ϕ2 which changes in the counterclockwise direction from the north pole toward the south pole.

A magnetic detection device 10 of a first embodiment of the invention is fixed in a position facing the outer circumference surface 3a of the rotation magnet 3. The magnetic detection device 10 has a substrate 11, but the surface of the substrate 11 is disposed in parallel to a planar surface perpendicular with the rotation axis O.

The detection rotor 2 can be rotated by a manual operation or can be rotated along with an operation portion of various devices. When rotating, the leakage of magnetic field from the outer circumference surface 3a of the rotation magnet 3 is detected by the magnetic detection device 10.

As shown in Figs. 1 and 2, the magnetic detection device 10 is provided with two detection units 15A and 15B on the surface of the substrate 11. The planar shape of the detection units 15A and 15B is a quadrangle, and a blank region 12 with a strip shape is provided between the detection unit 15A on the left side and the detection unit 15B on the right side. In the blank region 12, a circuit part and a line pattern which configure the detection unit 15A and a circuit part or a line pattern which configure the detection unit 15B is not provided. However, a power source line portion 17 and a ground line portion 18 which couple the detection unit 15A on the left side and the detection unit 15B on the right side cross the blank region 12. In the

blank region 12, there are no circuit configuring members other than the power source line portion 17 and the ground line portion 18.

As shown in Fig. 2, the detection unit 15A on the left side and the detection unit 15B on the right side have exactly the same structure, each part and arrangement pattern of each terminal portion are exactly the same except for the power source line portion 17 and the ground line portion 18. As such, each of the parts, the terminal portions and the line patterns of the detection unit 15A on the left side and the detection unit 15B on the right side are formed by the same process at the same time.

The detection unit 15A on the left side and the detection unit 15B on the right side each have a circuit configuring layer 20. The circuit configuring layer 20 provided in the detection unit 15A and the circuit configuring layer 20 provided in the detection unit 15B are exactly the same. As shown in Fig. 3, each of the circuit configuring layers 20 has an integrated circuit and is configured by forming each various type of conductor layer, semiconductor layer and insulating layer on the surface of the substrate 11 by a thin film process. As shown in Fig. 2, the planar shape of the circuit configuring layer 20 is substantially the same as the planar shape of each of the detection units 15A and 15B.

In the circuit diagram shown in Fig. 4, the portion surrounded by solid-line box is a circuit provided in an inner portion of the circuit configuring layer 20. In the inner portion of the circuit configuring layer 20, a detection circuit 21, which obtains a detection output according to a change in the resistance value of a magnetoresistance effect element, is configured.

As shown in Fig. 3, in the circuit configuring layer 20, the detection circuit 21 formed on the surface of the substrate 11 is covered by an insulating layer, and on an upper surface 20a of the circuit configuring layer 20 which is a surface of the insulating layer, a plurality of relay terminals which conduct to the detection circuit 21 is provided. Below, the relay terminals will be described while contrasting Figs. 2 and 4.

As shown in Fig. 2, on each of the upper surfaces 20a of the circuit configuring layers 20, there are a first power source relay terminal 22, a ground relay terminal 23, an input relay terminal 24 and a second power source relay terminal 25. The relay terminals 22, 23, 24 and 25 are formed by conductive metallic materials with low resistance such as silver or gold and are exposed to the upper surface 20a of the circuit configuring layer 20. In addition, in Fig. 3, a state where the input relay terminal 24 is exposed to the upper surface 20a of the circuit configuring layer 20 and conducts with the detection circuit 21 in the inner portion of the circuit configuring layer 20 is shown in a cross-sectional diagram.

As shown in the circuit diagram of Fig. 4, a ground conducting terminal 26 is provided in the detection circuit 21. As shown in the cross-sectional diagram of Fig. 3, the ground conducting terminal 26 is exposed to the upper surface 20a of the circuit configuring layer 20 and is connected to a connection line 43 of the detection circuit 21 in the circuit configuring layer 20. As shown in Fig. 3, a common external insulating layer 19 covers the top of the circuit configuring layer 20 which is formed by the detection unit 15A on the left side and the circuit configuring layer 20 which is formed by the detection unit 15B on the right side. The external insulating layer 19 is an organic insulating film or an inorganic insulating film. On the ground conducting terminal 26, a ground terminal portion 31 is formed in a bump shape, and the ground terminal portion 31 conducts with the ground conducting terminal 26 and is exposed to a surface 19a of the external insulating layer 19.

As shown in the circuit diagram of Fig. 4, a power source conducting terminal 27 and an output conducting terminal 28 are provided in the detection circuit 21. The power source conducting terminal 27 and the output conducting terminal 28 are exposed to the upper surface 20a of the circuit configuring layer 20 and are connected to the detection circuit 21 in the same manner as the ground conducting terminal 26. In addition, a power source terminal portion 32 with a bump shape is provided on the power source conducting terminal 27, and the power source terminal portion 32 conducts with the power source conducting terminal 27 and is exposed to the surface 19a of the external insulating layer 19. In the same manner, an output terminal portion 33 is formed in a bump shape on the output conducting terminal 28, and the output terminal portion 33 conducts with the output conducting terminal 28 and is exposed to the surface 19a of the external insulating layer 19.

The ground terminal portion 31, the power source terminal portion 32 and the output terminal portion 33 are formed by a metallic material and the portion exposed to the surface 19a of the external insulating layer 19 is formed by a conductive material such as gold which is difficult to oxidize.

The ground terminal portion 31, the power source terminal portion 32 and the output terminal portion 33 are formed together in a process at the detection unit 15A on the left side and the detection unit 15B on the right side. As shown in Fig. 2, the arrangement of the ground terminal portion 31, the power source terminal portion 32 and the output terminal portion 33 are the same at the detection unit 15A on the left side and the detection unit 15B on the right side.

As shown in Fig. 4, a reference resistor 41 and a reference resistor 42 connected in series are provided in the detection circuit 21. The end portion of the reference resistor 41 is connected to the first power source relay terminal 22 and the end portion of the reference resistor 42 is connected to the ground relay terminal 23. Additionally, the ground relay terminal 23 and the ground conducting terminal 26 conduct via the connection line 43 wired in the inner portion of the circuit configuring layer 20. In Fig. 3, a portion of the connection line 43 is shown in cross section.

In the inner portion of the detection circuit 21, a differential amplifier 44, a Schmitt trigger circuit 45 and a latch circuit 47 are configured. A connection midpoint 46 of the reference resistor 41 and the reference resistor 42 and the input relay terminal 24 are connected to the differential amplifier 44. An output from the differential amplifier 44 is applied to the latch circuit 47 via the Schmitt trigger circuit 45. Then, an output switch portion 48 is changed by a high or low voltage value held in the latch circuit 47.
The output switch portion 48 is configured by two transistors 48a and 48b provided in the circuit configuring layer 20.
The one transistor 48a is connected to the power source conducting terminal 27, the other transistor 48b is connected to the ground conducting terminal 26 and the connection midpoint of the transistor 48a and the transistor 48b is connected to the output conducting terminal 28.

A timing circuit 49 which includes a clock circuit is provided in the inner portion of the detection circuit 21. The timing circuit 49 is controlled by signals applied to a control conducting terminal 29. The control conducting terminal 29 is provided on the surface of the circuit configuring layer 20, a control terminal portion with a bump shape is provided thereon, and the control terminal portion is exposed to the surface of the external insulating layer 19. In addition, the diagrammatic illustration of the control terminal portion is omitted in Fig. 2. The control conducting terminal 29 and the timing circuit 49 are connected by a connection line 29a provided in the inner portion of the circuit configuring layer 20. A switch circuit 51 is provided between the first power source relay terminal 22 and the power source conducting terminal 27. The switch circuit 51 is operated by a change timing with a constant interval set by the timing circuit 49. The connection and disconnection of the first power source relay terminal 22 and the power source conducting terminal 27 are repeated with a constant frequency. In the detection circuit 21, by applying a power source voltage VDD intermittently using the switch circuit 51, it is possible to reduce power consumption.

The latch circuit 47 is controlled by the timing circuit 49, and the latch circuit 47 detects an output from the Schmitt trigger circuit 45 and holds the output in accordance with the timing when the switch circuit 51 is connected.

As shown in Figs. 2 and 4, the second power source relay terminal 25 and the power source conducting terminal 27 conduct via a connection line 52 formed in the inner portion of the circuit configuring layer 20.

After the circuit configuring layer 20 of the detection unit 15A on the left side and the circuit configuring layer 20 of the detection unit 15B on the right side are formed, on each of the upper surfaces 20a of the circuit configuring layers 20, a magnetoresistance effect element 55 and a fixed resistor 56 are formed. As shown in Fig. 2, the magnetoresistance effect element 55 and the fixed resistor 56 are formed so as to each become a meander pattern. In Fig. 3, the magnetoresistance effect element 55 is shown in a cross-sectional diagram.

As shown in Fig. 2, on the upper surface 20a of the circuit configuring layer 20, an electrode layer 57 is formed which is connected to one end of the magnetoresistance effect element 55. The electrode layer 57 extends on top of the ground relay terminal 23 which exists on the upper surface 20a of the circuit configuring layer 20. Due to the electrode layer 57, the magnetoresistance effect element 55 and the ground relay terminal 23 are connected. On the upper surface 20a of the circuit configuring layer 20, an electrode layer 58 is formed which is connected to an end portion of the fixed resistor 56. The electrode layer 58 extends on top of the first power source relay terminal 22, and due to the electrode layer 58, the fixed resistor 56 and the first power source relay terminal 22 are connected. The electrode layer 57 is set as a ground portion and the electrode layer 58 is set as a positive potential applying portion.

As shown in Fig. 2, on the upper surface 20a of the circuit configuring layer 20, an intermediate electrode layer 59 is formed which connects the magnetoresistance effect element 55 and the fixed resistor 56 in series. As shown in Figs. 2 and 3, the intermediate electrode layer 59 is formed on top of the input relay terminal 24, and the connection midpoint of the magnetoresistance effect element 55 and the fixed resistor 56 is connected to the differential amplifier 44 via the input relay terminal 24.

As shown in Fig. 2, the power source line portion 17 and the ground line portion 18 are formed from the upper surface 20a of the circuit configuring layer 20 of the detection unit 15A on the left side to the upper surface 20a of the circuit configuring layer 20 of the detection unit 15B on the right side via the blank region 12. In the blank region 12, the power source line portion 17 and the ground line portion 18 are formed on the surface of the substrate 11 at a position lower than the upper surface 20a of the circuit configuring layer 20. The second power source relay terminal 25 which exists on the upper surface 20a of the circuit configuring layer 20 of the detection unit 15A on the left side and the second power source relay terminal 25 which exists on the upper surface 20a of the circuit configuring layer 20 of the detection unit 15B on the right side are connected by the power source line portion 17. Additionally, the ground relay terminal 23 which exists on the upper surface 20a of the circuit configuring layer 20 of the detection unit 15A on the left side and the ground relay terminal 23 which exists on the upper surface 20a of the circuit configuring layer 20 of the detection unit 15B on the right side are connected by the ground line portion 18.

In the manufacturing process of the magnetic detection device 10, after the plurality of circuit configuring layers 20 is formed on the substrate 11 while opening a constant interval, the magnetoresistance effect element 55 and the fixed resistor 56 are each formed at the same time on the upper surfaces 20a of all of the circuit configuring layers 20 by the same thin film process. After this, the electrode layer 57, the electrode layer 58 and the intermediate electrode layer 59 are formed on the upper surfaces 20a of all of the circuit configuring layers 20 similarly by the thin film process. Then, in the same process as the forming of the electrode layers 57, 58 and 59, the power source line portion 17 and the ground line portion 18 which connect between the adjacent detection units 15A and 15B are formed. In addition, the power source line portion 17 and the ground line portion 18 may be formed in a different process after the electrode layers 57, 58 and 59 are formed.

As shown in Fig. 3, after the electrode layers 57 and 58, the intermediate electrode 59, the power source line portion 17 and the ground line portion 18 are formed, the external insulating layer 19 is formed. After this, in each of the detection units 15A and 15B, the ground terminal portion 31, the power source terminal portion 32 and the output terminal portion 33 are formed.

After the laminate shown in Fig. 3 is completed, the substrate 11 is cut in the blank region between the adjacent detection units, and as shown in Fig. 2, the magnetic detection device 10 is completed with the detection unit 15A and the detection unit 15B becoming a pair.

Next, the structure of the magnetoresistance effect element 55 will be described based on Figs. 5 and 6.

As shown in Fig. 5, in the magnetoresistance effect element 55, a plurality of element portions 61 is formed in parallel to each other. The front and back end portions of each of the element portions 61 are connected in lots of two by the connection electrodes 62a and 62b and are configured in a meander pattern. Additionally, the magnetoresistance effect element 55 may be formed in a meander pattern by only the laminate structure of the element portions 61 shown in Fig. 6 without having the connection electrodes 62a and 62b.

As shown in the cross-sectional diagram of Fig. 6, each of the element portions 61 has an antiferromagnetic layer 63, a fixed magnetic layer 64, a nonmagnetic conductive layer 65 and a free magnetic layer 66 laminated in this order and deposited on the upper surface 20a of the circuit configuring layer 20, and the surface of the free magnetic layer 66 is covered by a protective layer 67.

The antiferromagnetic layer 63 is formed by an antiferromagnetic material such as an Ir-Mn alloy (iridium-manganese alloy). The fixed magnetic layer 64 is formed by a soft magnetic material such as a Co-Fe alloy (cobalt-iron alloy). The nonmagnetic conductive layer 65 is Cu (copper) or the like. The free magnetic layer 66 is formed by a soft magnetic material such as a Ni-Fe alloy (nickel-iron alloy). The protective layer 67 is a Ta (tantalum) layer.

In the element portion 61, due to the antiferromagnetic coupling of the antiferromagnetic layer 63 and the fixed magnetic layer 64, the direction of the magnetization of the fixed magnetic layer 64 is fixed. The direction (P direction) of the fixed magnetization of the fixed magnetic layers 64 of each of the element portions 61 is an orientation perpendicular to the longitudinal direction of the element portions 61.

As shown in Fig. 2, in the detection unit 15A and the detection unit 15B, the longitudinal direction of the element portions 61 of each of the magnetoresistance effect elements 55 is formed in an orientation perpendicular to a long side 11a of the substrate 11. As such, the direction (P direction) of the fixed magnetization of the magnetoresistance effect element 55 shown in Fig. 5 is an orientation parallel to the long side 11a of the substrate 11. Additionally, in each of the detection units 15A and 15B, the magnetoresistance effect element 55 is formed in a position closer to the long side 11a than the fixed resistor 56.

As shown in Fig. 1, in the magnetic detection device 10, the surface of the substrate 11 is parallel to a planar surface perpendicular to the rotation axis O of the detection rotor 2 and the long side 11a of the substrate 11 is positioned to face the outer circumference surface 3a of the rotation magnet 3. In each of the detection units 15A and 15B, since the magnetoresistance effect element 55 is disposed in a position close to the long side 11a, the magnetization of the free magnetic layers 66 of each of the element portions 61 typically becomes saturated by the leakage of magnetic field from the outer circumference surface 3a of the rotation magnet 3.

As shown in Fig. 1, in the rotation magnet 3, the magnetic flux ϕ1 and ϕ2 between adjacent magnetic poles in the outer circumference surface 3a exist as magnetic flux leakage.

Here, when arrangement pitch of the north poles and the arrangement pitch of the south poles on the outer circumference surface 3a of the rotation magnet 3 is set as one cycle, the gap between the detection unit 15A and the detection unit 15B on the substrate 11 is determined so that the gap between the magnetoresistance effect element 55 provided in the detection unit 15A and the magnetoresistance effect element 55 provided in the detection unit 15B in connection line direction of the outer circumference surface 3a is 1/4 of a cycle. That is, when the cycle where the north pole and the south pole move in a forward direction of the magnetic detection device 10 is set to 360 degrees, the pitch of the detection unit 15A and the detection unit 15B is set so as to be equivalent to a cycle of 90 degrees.

Next, the detection operation of the magnetic detection device 10, when the rotation magnet 3 of the magnetic detection encoder 1 shown in Fig. 1 is rotated, will be described.

The magnetic detection device 10 is provided with two of the detection unit 15A and the detection unit 15B side by side on the substrate 11 and each has the ground terminal portion 31, the power source terminal portion 32 and the output terminal portion 33. However, in the detection unit 15A and the detection unit 15B, the second power source relay terminals 25 which are positive potential applying portions are connected to each other by the power source line portion 17 and the ground relay terminals 23 which are the ground portions are connected to each other by the ground line portion 18. As a result, only either one of the two power source terminal portions 32 and 32 shown in Fig. 2 is applied with the positive potential of the power source circuit, and only either one of the two ground terminal portions 31 and 31 shown in Fig. 2 is connected with the ground potential. Therefore, it is possible to supply power to each of the detection circuits 21 and 21 of the two detection units 15A and 15B at the same time.

In addition, it is possible to obtain individual detection output from the output terminal portion 33 of the detection unit 15A and the output terminal portion 33 of the detection unit 15B. Since the arrangement gap of the detection units 15A and 15B facing the outer circumference surface 3a of the rotation magnet 3 shown in Fig. 1 is equivalent to 1/4 of the cycle with regard to one cycle of the change in the magnetic field, it is possible to individually obtain detection output, where the phase differs from each other by 90 degrees, from the output terminal portion 33 of the detection unit 15A and the output terminal portion 33 of the detection unit 15B.

Since the detection output where the phase differs by 90 degrees is obtained from the detection unit 15A and the detection unit 15B, it is possible to not only detect the number of rotations of the detection rotor 2 but also the rotation direction.

Below, the detection operation at the one detection unit 15A will be described but the detection operation at the other detection unit 15B is also exactly the same. The line diagrams of Figs. 7A and 7B show the detection operation of the one detection unit 15A, but in the detection operation of the other detection unit 15B, the phase of the waveform is deviated by only 90 degrees from the detection unit 15A and the detection operation itself is the same as the detection unit 15A.

When the detection rotor 2 rotates and the outer circumference surface 3a of the rotation magnet 3 moves in a side direction of the magnetic detection device 10, since the orientation of the magnetic flux elements ϕ1 and ϕ2, which saturate the free magnetic layer 66 of the magnetoresistance effect element 55, changes, a vector F of the magnetization of the free magnetic layer 66 rotates in a surface perpendicular to the rotation axis O. When the rotation magnet 3 rotates by 45 degrees which is the angle of one pitch of the magnetization, that is, only by an angle equivalent to one cycle of the alternate magnetization repeating north-south-north, the vector F of the magnetization of the free magnetic layer 66 rotates 360 degrees.

In the magnetoresistance effect element 55, the electrical resistance changes due to a relationship between the direction (P direction) of the fixed magnetization of the fixed magnetic layer 64 and the direction of the vector F of the magnetization of the free magnetic layer 66. When the vector F of the magnetization of the free magnetic layer 66 becomes parallel with the direction (P direction) of the fixed magnetization, the electrical resistance is extremely small, and when the vector F is anti-parallel with the direction (P direction) of the fixed magnetization, the electrical resistance is extremely large.

In the detection circuit 21 shown in Fig. 4, when the switch circuit 51 is intermittently connected by the timing circuit 49, the power source voltage VDD is applied between the first power source relay terminal 22 and the ground relay terminal 23. Since the orientation of the vector F of the magnetization of the free magnetic layer 66 of the magnetoresistance effect element 55 provided in the detection unit 15A rotates in accompaniment with the rotation of the rotation magnet 3, the resistance value of the magnetoresistance effect element 55 changes. Accompanying this, the potential at the midpoint of the magnetoresistance effect element 55 and the fixed resistor 56 changes, and the change of potential is applied from the input relay terminal 24 to the differential amplifier 44. Additionally, the potential (VDD/2) at the connection midpoint 46 of the reference resistor 41 and the reference resistor 42 is also applied to the differential amplifier 44.

From the differential amplifier 44, the voltage of the connection midpoint 46 of the reference resistor 41 and the reference resistor 42 is used as a standard, and relative to this, the amount of increase or decrease in the voltage applied to the input relay terminal 24 is output, and the output is applied to the Schmitt trigger circuit 45. Fig. 7A shows the change in the voltage applied to the Schmitt trigger circuit 45 from the differential amplifier 44. The change in the voltage resembles a sine waveform or a cosine waveform, and while the rotation magnet 3 shown in Fig. 1 rotates by just an angle of 45 degrees, the voltage output changes only for one cycle.

In the Schmitt trigger circuit 45, when the voltage difference detected by the differential amplifier 44 exceeds a first threshold value L1, a high output is applied to the latch circuit 40 and a high value is held, and when the voltage difference is lower than a second threshold value L2, a low output is applied to the latch circuit 40 and a low value is held. In the latch circuit 40, when the high output can be obtained from the Schmitt trigger circuit 45, the output switch circuit 48 is turned ON, and when the output from the Schmitt trigger circuit 45 changes to low, the output switch circuit 48 is turned OFF.

As such, as shown in Fig. 7B, from the output terminal portion 33, a square wave can be obtained which falls when the output voltage from the differential amplifier 44 exceeds the first threshold value L1 and which rises when the output voltage from the differential amplifier 44 is lower than the second threshold value L2.

Also, as described above, from each of the output terminal portion 33 of the detection unit 15A and the output terminal portion 33 of the detection unit 15B, there are the same square waves as shown in Fig. 7B, and square waves where the phase is deviated from each other by only T/4 can be obtained.

Fig. 8 is a planar diagram illustrating a magnetic detection device 110 according to a second embodiment of the present invention.

The magnetic detection device 110 is provided with two detection units 15 and 115 on the surface of the substrate 11. The detection unit 15 on the left side is exactly the same as the detection units 15A and 15B shown in Fig. 2. Each member of the detection unit 115 on the right side is disposed so that the detection unit 115 becomes a line symmetrical form with a line LO-LO, which divides the blank region 12 between the two detection units 15 and 115 in a width direction, as a boundary.

Each of the constituent members of the detection unit 15 and the detection unit 115 is referenced by the same reference numeral for the same constituent element since only the arrangement is line symmetrical and the structure is the same.

In addition, the second power source relay terminal 25 of the detection unit 15 and the second power source relay terminal 25 of the detection unit 115 are coupled by a power source line portion 117, and the ground relay terminal 23 of the detection unit 15 and the ground relay terminal 23 of the detection unit 115 are coupled by a ground line portion 118.

In addition, it is possible to configure the magnetic detection device as a magnetic detection device where 3 detection units or more than 3 detection units are mounted on the same substrate 11. Additionally, since each of the detection units has a structure where each is able to function so each can be an independent magnetic detection device as shown in Figs. 4 and 8, it is possible for the substrate 11 to be cut in the blank region 12 and for each of the detection units to be used as a magnetic detection device having the one detection unit.

In this case, it is possible to detect the rotation speed of the detection rotor 2 and the like by facing the outer circumference surface 3a of the rotation magnet 3 of the magnetic detection encoder shown in Fig. 1. Additionally, it is possible to configure a proximity switch or the like using the magnetic detection device having the one detection unit.

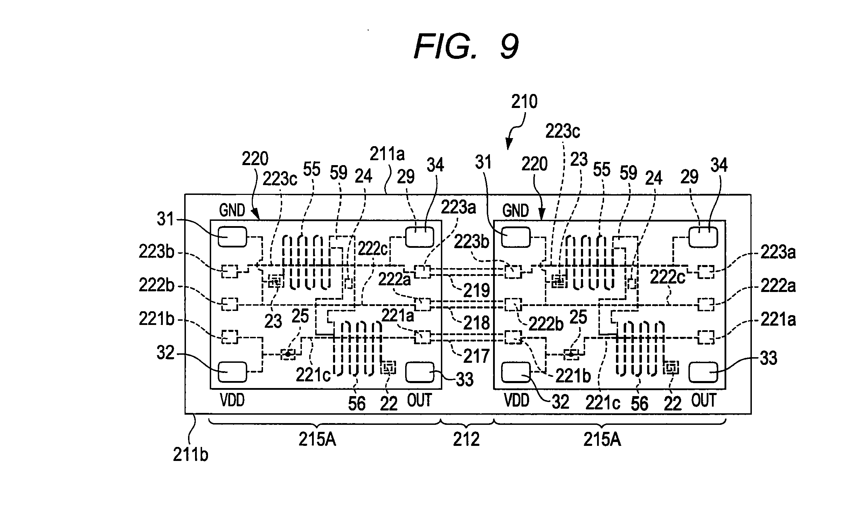

Fig. 9 is a planar diagram illustrating a magnetic detection device 210 according to a third embodiment of the present invention.

The magnetic detection device 210 according to the third embodiment of the present invention is provided with detection units 215A and 215B side by side on the surface of a substrate 211 and is provided with a blank region 212 with a strip shape between both of the detection units 215A and 215B.

The detection unit 215A and the detection unit 215B are manufactured with the same structure by the same process. In Fig. 9, out of the elements which configure each of the detection units 215A and 215B, the same parts of the constituent members of the magnetic detection device 10 according to the first embodiment shown in Figs. 2 and 4 are referenced by the same reference numbers and a detailed description has been omitted.

The detection unit 215A and the detection unit 215B are each provided with a circuit configuring layer 220. In an inner portion of the circuit configuring layer 220, the same detection circuit 21 as shown in Fig. 4 is configured.

On the surface of each of the circuit configuring layers 220, there are the ground conducting terminal 26, the power source conducting terminal 27 and the output conducting terminal 28 shown in Fig. 4, and the ground terminal portion 31 with a bump shape is formed on the ground conducting terminal 26, the power source terminal portion 32 with a bump shape is formed on the power source conducting terminal 27, and the output terminal portion 33 with a bump shape is formed on the output conducting terminal 28. Furthermore, there is the control conducting terminal 29 on the surface of the circuit configuring layer 20, and a control terminal portion 34 with a bump shape is provided thereon.

In a side portion on the right side of each of the detection unit 215A and the detection unit 215B, a right-side power source coupling terminal 221a, a ground coupling terminal 222a and a control coupling terminal 223a are provided on an upper surface of the circuit configuring layer 220. In a side portion on the left side of each of the detection unit 215A and the detection unit 215B, a left-side power source coupling terminal 221b, a ground coupling terminal 222b and a control coupling terminal 223b are provided on the upper surface of the circuit configuring layer 220.

In the inner portion of the circuit configuring layer 220, connection lines 221c, 222c and 223c are wired. The second power source relay terminal 25 and each of the right and left power source coupling terminals 221a and 221b are connected by the connection line 221c. Also, the ground relay terminal 23 and each of the right and left ground coupling terminals 222a and 222b are connected by the connection line 222c. Furthermore, the control conducting terminal 29 and each of the right and left control coupling terminals 223a and 223b are formed by the connection line 223c.

In the detection unit 215A and the detection unit 215B, the magnetoresistance effect element 55, the fixed resistor 56, the intermediate electrode layer 59 and the like are formed on the surface of the circuit configuring layer 220. On the upper surface of the circuit configuring layer 220, the right-side power source coupling terminal 221a, the ground coupling terminal 222a and the control coupling terminal 223a are provided in a right side portion, and the left-side power source coupling terminal 221b, the ground coupling terminal 222b and the control coupling terminal 223b are provided in a left side portion, and a region in the middle thereof opens up widely without there being any line layers. As a result, it is possible for the magnetoresistance effect element 55 and the fixed resistor 56 to be freely disposed on the upper surface of the circuit configuring layer 220. For example, as shown in Fig. 9, the magnetoresistance effect element 55 is disposed in a position close to a long side 211a of the substrate 211, and it is possible to dispose the fixed resistor 56 in a position close to a different long side 211b so that at least a part of the fixed resistor 56 overlaps with the magnetoresistance effect element 55, and as a result, it is possible to configure the detection units 215A and 215B in a small size.

Additionally, in the blank region 212, a power source line portion 217 is formed which conducts between the power source coupling terminal 221a of the detection unit 215A on the right side and the power source coupling terminal 221b of the detection unit 215B on the left side, and a ground line portion 218 is formed which conducts between the ground coupling terminal 222a of the detection unit 215A on the right side and the ground coupling terminal 222b of the detection unit 215B on the left side. Additionally, a control line portion 219 is formed which conducts between the control coupling terminal 223a of the detection unit 215A on the right side and the control coupling terminal 223b of the detection unit 215B on the left side.

The power source line portion 217, the ground line portion 218 and the control line portion 219 are formed from the right edge of the upper surface of the circuit configuring layer 220 of the detection unit 215A to the left edge of the upper surface of the circuit configuring layer 220 of the detection unit 215B via the top of the blank region 212 of the substrate 211. As shown in Fig. 3, the two detection units 215A and 215B are covered by the external insulating layer 19, and the power source line portion 217, the ground line portion 218 and the control line portion 219 are also covered by the external insulating layer 19 and insulated. Additionally, there are the ground terminal portion 31, the power source terminal portion 32, the output terminal portion 33 and the control terminal portion 34 on the surface of the external insulating layer 19.

As long as the length dimensions of the power source line portion 217, the ground line portion 218 and the control line portion 219 are sufficient only to cross the blank region 212, it is possible for the length dimensions to be as short as possible and for the resistance value to be reduced. Additionally, the connection lines 221c, 222c, and 223c which respectively connect the right-side power source coupling terminal 221a, the ground coupling terminal 222a and the control coupling terminal 223a to the left-side power source coupling terminal 221b, the ground coupling terminal 222b and the control coupling terminal 223b are formed in the inner portion of the circuit configuring layer 220. Therefore, it is possible to form the connection lines 221c, 222c, and 223c to be thicker than the power source line portion 217, the ground line portion 218 and the control line portion 219 and for the cross-sectional area to be larger. As a result, it is possible for the resistance value per unit length of the connection lines 221c, 222c, and 223c to be lower than the resistance value per unit length of the power source line portion 217, the ground line portion 218 and the control line portion 219. Accordingly, by forming the power source line portion 217, the ground line portion 218 and the control line portion 219 to be as short as possible, it is possible to reduce the resistance value of the entire circuit.

By supplying a power source to either one of the power source terminal portions 32 and setting either one of the ground terminal portions 31 as the ground potential, it is possible for the magnetic detection device 210 shown in Fig. 9 to drive both of the detection units 215A and 215B. Additionally, it is possible to obtain individual detection outputs of the detection unit 215A and the detection unit 215B from the two output terminal portions 33. Additionally, by applying a control signal to either one of the control terminal portions 34, it is possible for the timing circuits 49 of both of the detection units 215A and 215B to be controlled.

## Claims

1. A magnetic detection device,
wherein, a plurality of detection units, which has a magnetoresistance effect element and a detection circuit which detects a change in a resistance value of the magnetoresistance effect element, is provided on the same substrate;
each of the detection units is individually provided with a power source terminal portion which applies a positive potential, a ground terminal portion which sets a ground potential, and an output terminal portion which obtains a detection output generated by the detection circuit based on a change in the resistance value; and
a plurality of positive potential applying portions of the detection units are connected to each other by a power source line portion and a plurality of ground portions of the detection units are connected to each other by a ground line portion, so that it is possible to apply a positive potential to all of the positive potential applying portions of the detection units using any one of the power source terminal portions and to set a ground potential in all of the ground portions of the detection units using any one of the ground terminal portions, and it is possible to obtain a detection output of each of the detection units from the respective output terminal portions.

2. The magnetic detection device according to Claim 1, wherein, a blank region with a strip shape, where the magnetoresistance effect element and the detection circuit do not exist between the adjacent detection units, is provided, and the power source line portion which connects the positive potential applying portions of the adjacent detection units and the ground line portion which connects the ground portions of the adjacent detection units cross the blank region.

3. The magnetic detection device according to Claims 1 or 2,
wherein, each of the detection units has a fixed resistor connected in series with the magnetoresistance effect element, and one end portion of the magnetoresistance effect element and the fixed resistor connected in series is set as the positive potential applying portion and the other end portion thereof is set as the ground portion, and the potential at the midpoint of the magnetoresistance effect element and the fixed resistor is applied to the detection circuit.

4. The magnetic detection device according to Claim 3, wherein, each of the detection units is formed of the magnetoresistance effect element, the fixed resistor, an electrode layer which connects between the magnetoresistance effect element and the fixed resistor, an electrode layer connected to the other end portion of the magnetoresistance effect element, and an electrode layer connected to the other end portion of the fixed resistor, on a circuit configuring layer which configures the detection circuit; and
in each of the detection units, the power source line portion and the ground line portion are formed on the circuit configuring layer.

5. The magnetic detection device according to Claim 4, wherein, a power source relay terminal and a ground relay terminal are provided on the circuit configuring layer, and using a connection line provided at an inner portion of the circuit configuring layer, the power source terminal portion and the power source relay terminal are connected to each other and the ground terminal portion and the ground relay terminal are connected to each other; and
the power source relay terminal is connected to the power source line portion and the ground relay terminal is connected to the ground line portion.

6. The magnetic detection device according to Claims 1 or 2,
wherein, in each of the detection units, a right-side power source coupling terminal and a right-side ground coupling terminal are provided on one side portion facing the arrangement direction of the detection unit, a left-side power source coupling terminal and a left-side ground coupling terminal are provided on the other side portion, the power source terminal portion and each of the left-side and right-side power source coupling terminals are connected by a connection line, and the ground terminal portion and each of the left-side and right-side ground coupling terminals are connected by a connection line; and
between the adjacent detection units, the right-side power source coupling terminal of one detection unit and the left-side power source coupling terminal of another detection unit are connected by the power source line portion, and the right-side ground coupling terminal of one detection unit and the left-side ground coupling terminal of another detection unit are connected by the ground line portion.

7. The magnetic detection device according to Claim 6, wherein, each of the detection units is formed of the magnetoresistance effect element, the fixed resistor, an electrode layer which connects between the magnetoresistance effect element and the fixed resistor, an electrode layer connected to the other terminal of the magnetoresistance effect element, and an electrode layer connected to the other end portion of the fixed resistor, on the circuit configuring layer which configures the detection circuit; and
the connection line is wired in an inner portion of the circuit configuring layer, and the right-side and left-side power source coupling terminals and the right-side and left-side ground coupling terminals are provided on the circuit configuring layer.

8. The magnetic detection device according to Claim 7,
wherein, the cross-sectional area of the connection line is larger than the cross-section of the power source line portion and the ground line portion, and the resistance value per unit length of the connection line is smaller than the resistance value per unit length of the power source line portion and the ground line portion.

9. The magnetic detection device according to any of Claims 4, 5, 7 or 8,
wherein, the arrangement pattern of the
magnetoresistance effect element and the fixed resistor, the power source terminal portion and the ground terminal portion, and the output terminal portion is the same for all of the detection units.

10. The magnetic detection device according to Claims 4 or 5,
wherein, the arrangement patterns of the
magnetoresistance effect element and the fixed resistor, the power source terminal portion and the ground terminal portion, and the output terminal portion for adjacent detection units is line-symmetric via a boundary portion of the detection units.

11. The magnetic detection device according to any of Claims 4, 5, 7, 8, 9 or 10,
wherein, the magnetoresistance effect element is disposed to be closer to a predetermined edge portion of the substrate than the fixed resistor in all of the detection units.

12. The magnetic detection device according to Claim 11, further comprising:
a rotation magnet which has an outer circumference surface where a north pole and a south pole are alternatively magnetized toward a rotation direction;
wherein, the predetermined edge portion of the substrate which has two detection units faces the outer circumference surface of the rotation magnet, and when the rotation magnet rotates, detection outputs where the phases differ from each other can be obtained from the output terminal portions of the two detection units.
